Europäisches Patentamt

European Patent Office

Office européen des brevets

(19)

(11) Publication number: **0 184 464**
**B1**

(12) **EUROPEAN PATENT SPECIFICATION**

(45) Date of publication of patent specification: **14.06.89**

(21) Application number: **85308894.6**

(22) Date of filing: **06.12.85**

(51) Int. Cl.⁴: **H 01 L 27/02, G 06 F 15/06**

(54) **Gate array integrated circuit device and production method therefor.**

(30) Priority: **07.12.84 JP 258594/84**

(43) Date of publication of application:
**11.06.86 Bulletin 86/24**

(45) Publication of the grant of the patent:
**14.06.89 Bulletin 89/24**

(84) Designated Contracting States:
**DE FR GB**

(56) References cited:
**EP-A-0 079 127**

**IBM TECHNICAL DISCLOSURE BULLETIN, vol. 20, no. 10, March 1978, pages 3921-3922, New York, US; J.N. POMERANZ et al.: "Implementing array and logic functions on a single chip"**

**PATENTS ABSTRACTS OF JAPAN, vol. 8, no. 59 (E-232) 1496r, 17th March 1984 & JP - A - 58 210 638**

(73) Proprietor: **FUJITSU LIMITED**
**1015, Kamikodanaka Nakahara-ku**
**Kawasaki-shi Kanagawa 211 (JP)**

(72) Inventor: **Igarashi, Masato**
**4-3-10 Seijo**
**Setagaya-ku Tokyo 157 (JP)**
Inventor: **Suehiro, Yoshiyuki**
**103, Ouchihaitsu, 2-11-6, Suge**
**Tama-ku Kawasaki-shi Kanagawa 214 (JP)**

(74) Representative: **Billington, Lawrence Emlyn et al**
**HASELTINE LAKE & CO Hazlitt House 28**
**Southampton Buildings Chancery Lane**
**London WC2A 1AT (GB)**

(56) References cited:
**PATENTS ABSTRACTS OF JAPAN, vol. 6, no. 222 (E-140) 1100r, 6th November 1982 & JP - A - 57 124 463**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a gate array integrated device, and a production method therefor.

A gate array integrated circuit device is a semicustom LSI comprising a semiconductor chip which is prepared in advance by forming a number of basic cells in array on the semiconductor chip; these basic cells, such as the basic cells disclosed in Japanese Patent Application Publication No. 54-93375, constitute a basic unit of a logic circuit. In a semicustom LSI, when a customer requests a certain circuit, only the wiring between the basic cells need be changed, thereby enabling various logic circuit LSIs to be supplied with little delay.

When an arithmetic circuit such as an ALU is prepared from such a gate array integrated circuit device, a memory circuit is needed in addition to the logic circuit. As one method of realizing a memory in a gate array integrated circuit, there is known a method of constituting the memory by combining basic cells. However, many basic cells are necessary for constituting a memory so the service efficiency of the basic cells is deteriorated, and the memory area tends to be large.

To cope with the above problem, there has been proposed a gate array integrated circuit device in which a basic cell array and a memory exclusive region are provided together on the same semiconductor chip.

However, it is difficult for such a gate array integrated circuit device mentioned above to constitute a plurality of memories having different bit/word constitutions respectively, because the bit/word constitution of a memory cell matrix M of the device is fixed. Supposing a memory cell matrix M of 16 words×32 bits is prepared in advance. In this case, a memory such as a memory of 16 words×24 bits, in which a word is less than 32 bits, may be constituted without using a part of the memory cell matrix M. However, if a memory of 16 words×24 bits and a memory of 16 words×8 bits are required, one of the memories will be constituted by using the memory cell matrix M together with an address register AB, word decoder DEC, and clock buffer CB so that the other memory has to be clock buffer CB so that the other memory has to be constituted by combining many of the basic cells BC.

As mentioned above, previous gate array integrated circuit devices cannot completely realize a memory having a bit/word constitution satisfying the requirement of a customer, even if a memory exclusive region is provided therewith.

An embodiment of the present invention may provide a gate array integrated circuit device in which the integration ratio of the circuit is increased, and effectiveness in circuit designing is improved.

An embodiment of the present invention may provide a gate array integrated circuit which realizes a memory having a bit/word construction satisfying a customer's requirement, even if a memory exclusive region is provided therewith.

According to a first aspect of the present invention, there is provided a gate array integrated circuit device comprising a basic cell array region in which a plurality of basic cells are arranged, a memory cell matrix region in which a plurality of memory cells are arranged, and a plurality of peripheral circuits each of which includes address input circuits and decoders for accessing the memory cells so that said memory cell matrix region may be divided to form at least two independent memories having required bit/word constitutions, each having an address input circuit and a decoder.

According to a second aspect of the present invention there is provided a method for producing a semiconductor device comprising:

a process for forming in advance a semiconductor chip provided with a basic cell array region in which a plurality of basic cells are arranged, a memory cell matrix region in which a plurality of memory cells are arranged, and a plurality of peripheral circuits each of which includes address input circuits and decoders for accessing said memory cells:

a process for forming wiring for connecting the basic cells to each other to constitute a required logic circuit; and

a process for forming word lines separated in a word direction of said memory cell matrix or bit lines separated in a bit direction of said memory cell matrix according to a required bit/word constitution, forming at least a first and second group of word lines or bit lines, and connecting each of said groups of word lines or bit lines to a respective one of said plurality of peripheral circuits to constituted at least two independent memories having said required bit/word constitutions.

An embodiment of the invention may provide in advance two pairs of address input circuits and decoders as masters on a semiconductor chip to access a memory cell matrix of, for instance, 16 words×32 bits, which is a conventional type of matrix. If a customer requests, for instance, a memory of 24 bits×16 words and a memory of 8 bits×16 words, the memories will be formed by dividing word lines. Namely, a group of word lines is formed in which 24 memory cells are connected in a word direction and a group of word lines is formed in which 8 memory cells are connected in a word direction, each of the word line groups being connected to the address input circuits and word decoders to realize two independent memories having different bit/word constitutions respectively.

Reference is made, by way of example, to the accompanying drawings, in which:

Fig. 1 is a conceptual view showing a previously proposed gate array integrated circuit device;

Fig. 2 is a conceptual view showing an embodiment of the present invention;

Fig. 3 is a block diagram showing a memory portion of Fig. 2;

Figs. 4 to 8 are views showing examples of bit/word constitutions of memories realized according to the embodiment shown in Fig. 2;

Fig. 9 is a conceptual view showing another embodiment of the present invention;

Figs. 10 to 14 are views showing examples of bit/word constitutions of memories realized according to the embodiment shown in Fig. 9;

Fig. 15 is a view showing another embodiment of the present invention;

Figs. 16A, 16B, and 16C are diagrams showing a further embodiment of the present invention;

Fig. 17 is a diagram showing an essential portion of a concrete circuit in the memory shown in Fig. 16C;

Fig. 18 is a diagram showing an essential portion of a concrete circuit when the memory is formed as a read only memory;

Figs. 19A, 19B, 19C, and 19D are diagrams showing an essential portion of a further embodiment of the present invention;

Fig. 20 is a diagram showing an essential portion of a circuit of a still further embodiment of the present invention;

Figs. 21A and 21B are diagrams showing patterns corresponding to the circuit shown in Fig. 20; and

Fig. 22 is a diagram of an essential portion of the circuit of a still further embodiment of the present invention.

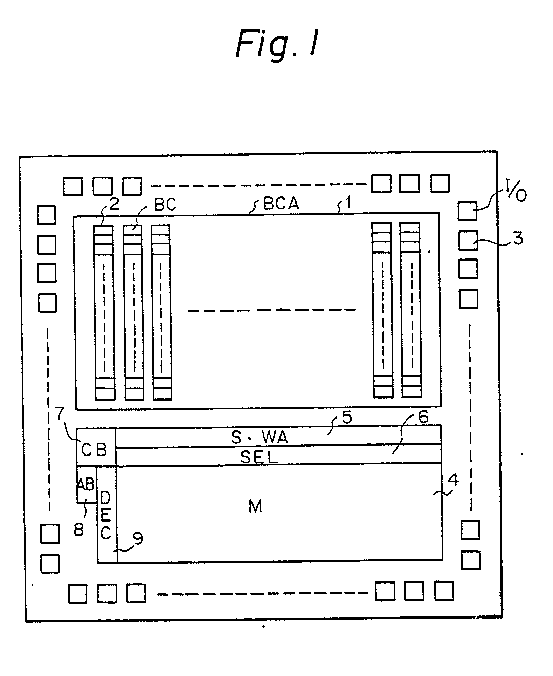

Figure 1 is a layout of a semiconductor chip of a gate array integrated circuit according to a previous proposal. In the Figure, reference numeral 1 represents a basic cell array region (BCA), 2 a basic cell (array) (BC), 3 an input/output buffer cell (I/O), 4 a memory cell matrix (M), 5 sense and write amplifiers (S · WA), 6 a column selector (SEL), 7 a clock buffer (CB), 8 an address register (AB), and 9 a word decoder (DEC).

In Fig. 1, various logic circuits can be realized by changing a wiring pattern of the basic cells and a wiring pattern between the basic cells. If a memory is required in the logic circuit, the memory matrix M is used for the purpose. Since transistors in the memory cell matrix M are arranged exclusively for providing memory, a memory having a large capacity is realized within a small area in comparison with the case in which a memory is made by combining the basic cells BC.

However, as already mentioned, it is difficult for such a gate array integrated circuit device to constitute a plurality of memories having different bit/word constitutions respectively, because the bit/word constitution of the memory cell matrix M of the device is fixed.

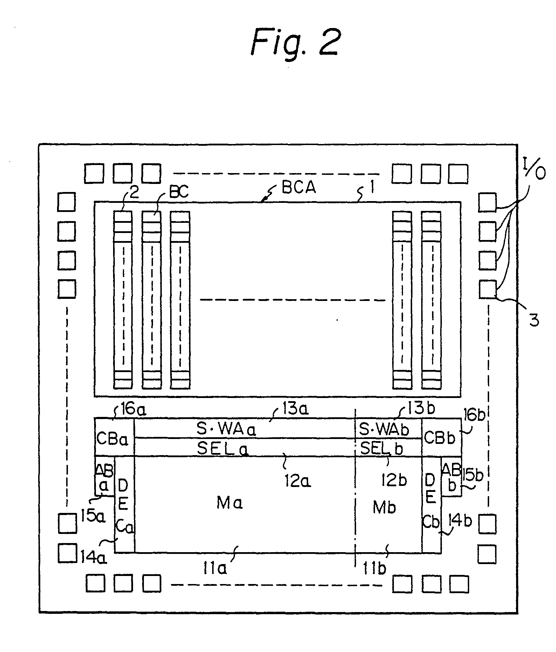

A first embodiment of the present invention will be explained with reference to Figures 2 to 8.

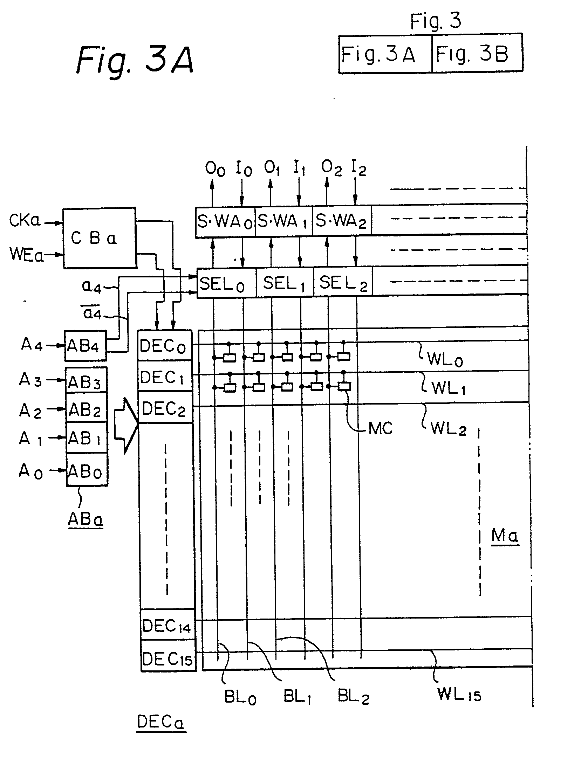

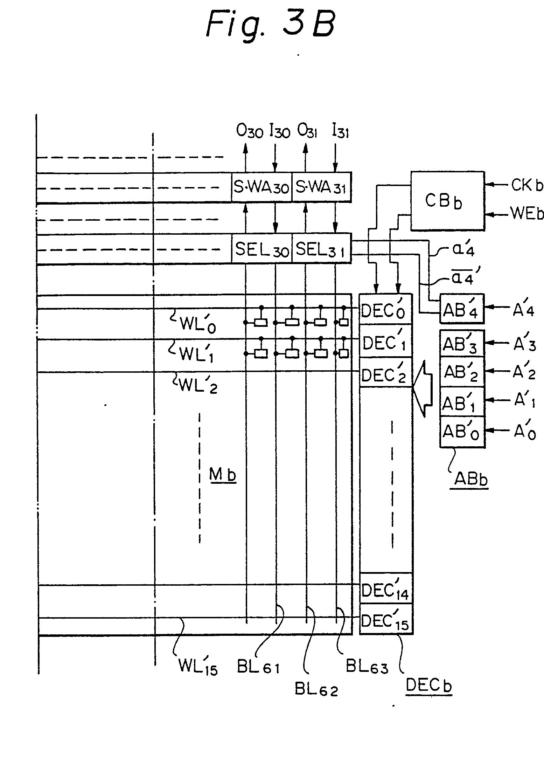

Figure 2 is a plan view showing a gate array integrated circuit device according to an embodiment of the present invention, and Fig. 3 a block diagram showing the detail of the constitution of a memory portion in the device showing in Fig. 2. In the Figures, "$M_a$" and "$M_b$" (11a, 11b) represent memory cell matrixes, "$SEL_a$" and

"$SEL_b$" (12a, 12b) column selectors, "$S \cdot WA_a$" and "$S \cdot WA_b$" (13a, 13b) sense and write amplifiers, "$DEC_a$" and "$DEC_b$" (14a, 14b) word decoders, "$AB_a$" and "$AB_b$" (15a, 15b) address registers, "$CB_a$" and "$CB_b$" (16a, 16b) clock buffers, "MC" (11) a memory cell, "$WL_0$" to "$WL_{15}$" and "$WL'_0$" to "$WL'_{15}$" word lines, "$BL_0$" to "$BL_{63}$" bit lines, "$CK_a$" and "$CK_b$" clock signals, "$WE_a$" and "$WE_b$" write enable signals, "$A_0$" to "$A_4$" and "$A'_0$" to "$A'_4$" addresses, "$I_0$" to "$I_{31}$" writes data, and "$O_0$" to "$O_{31}$" read data.

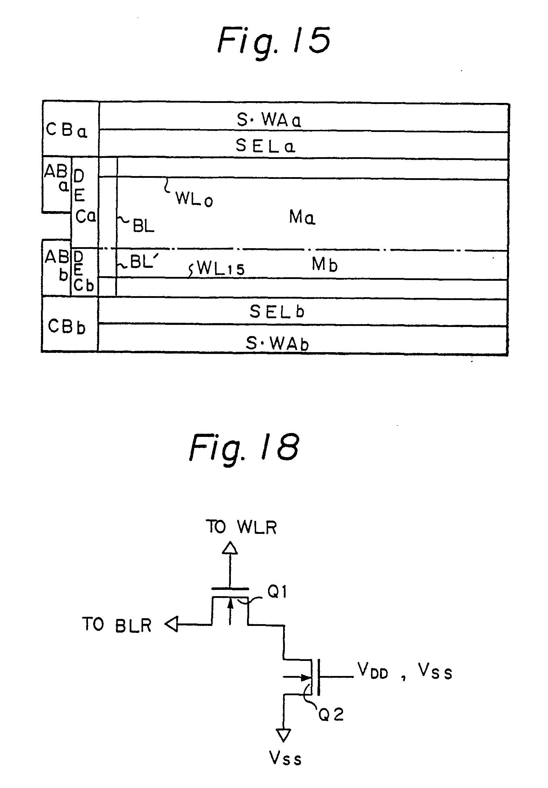

In the embodiment shown in Fig. 2, the memory cell matrixes $M_a$ and $M_b$ correspond to the memory cell matrix M shown in Fig. 15, the sense and write amplifiers $S \cdot WA_a$ and $S \cdot WA_b$ correspond to the $S \cdot WA$ shown in Fig. 15, and the column selectors $SEL_a$ and $SEL_b$ correspond to the SEL shown in Fig. 1. The present embodiment differs from previous devices in that the present embodiment is provided with two pairs of word decoders and address registers. According to such a constitution, word lines in a memory cell matrix may be divided as indicated by the alternate long and short dash line shown in Fig. 2, according to a customer's requirement, to form two independent memories each having a different bit/word constitution. Namely, the memory cell matrix $M_a$ is accessed by a system comprising the elements $AB_a$, $DEC_a$, $CB_a$, $SEL_a$, and $SW_a$, and the memory cell matrix $M_b$ by a system comprising the elements $AB_b$, $DEC_b$, $CB_b$, $SEL_b$, and $SW_b$. Details of the above will be described with reference to Fig. 3.

In the memory cell matrix shown in Fig. 3, there are arranged memory cells MC numbering 64×16. In this case, however, one of two bit lines is selected by a column selector. For instance, the column selector $SEL_0$, which may be regarded as a column decoder, selects the bit line $BL_0$ or $BL_1$ in response to complementary signals $a_4$ and $\bar{a}_4$ produced from an address A. Although the memory matrix has a constitution of e.g. 64 bits×16 words in a physical arrangement aspect, it has substantially (operationally) a constitution of 32 bits×32 words. Thus, if the sense and write amplifiers correspond one for one with respect to the bit lines, the column selectors $SEL_0$ to $SEL_{31}$ are not required. Further, the word decoder $DEC_a$ comprises decoders $DEC_0$ to $DEC_{15}$, and the address register $AB_a$ comprises registers $AB_0$ to $AB_4$, so that (only) the $DEC_a$ and $AB_a$ have access to all of the memory matrixes $M_a$ and $M_b$. The elements $DEC_b$ and $AB_b$ are constituted in a similar manner. As a result, the memory cell matrix can be divided at any location.

Since a gate array integrated circuit device is usually a semicustom LSI produced by a master slice method, a semiconductor chip incorporating elements for realizing the constitution shown in Fig. 2 is prepared in advance. According to a customer's request for a circuit, a wiring pattern between basic cells BC is formed. A wiring pattern in a memory is also decided according to the requirement of the customer as for the wiring between the basic cells BC. Supposing a memory

of 32 words×24 bits and a memory of 32 words×8 bits are constituted in Fig. 3. In this case, during the formation of a wiring pattern, word lines are divided into a word line group comprising $WL_0$ to $WL_{15}$ and a word line group comprising $WL'_0$ to $WL'_{15}$. The memory of 32 words×24 bits is constituted by connecting the memory cell matrix $M_a$, which includes bit lines $BL_0$ to $BL_{47}$ and word lines $WL_0$ to $WL_{15}$, with the word decoder $DEC_a$, address register $AB_a$, clock buffer $CB_a$, column selectors $SEL_0$ to $SEL_{23}$, and sense and write amplifiers $S \cdot WA_0$ to $S \cdot WA_{23}$. On the other hand, the memory of 32 words×8 bits is constituted by connecting the memory cell matrix $M_b$, which includes bit lines $BL_{48}$ to $BL_{63}$ and word lines $WL'_0$ to $WL'_{15}$, with the word decoder $DEC_b$, address register $AB_b$, clock buffer $CB_a$, column selectors $SEL_{24}$ to $SEL_{31}$, and sense and write amplifiers $S \cdot WA_{24}$ to $S \cdot WA_{31}$.

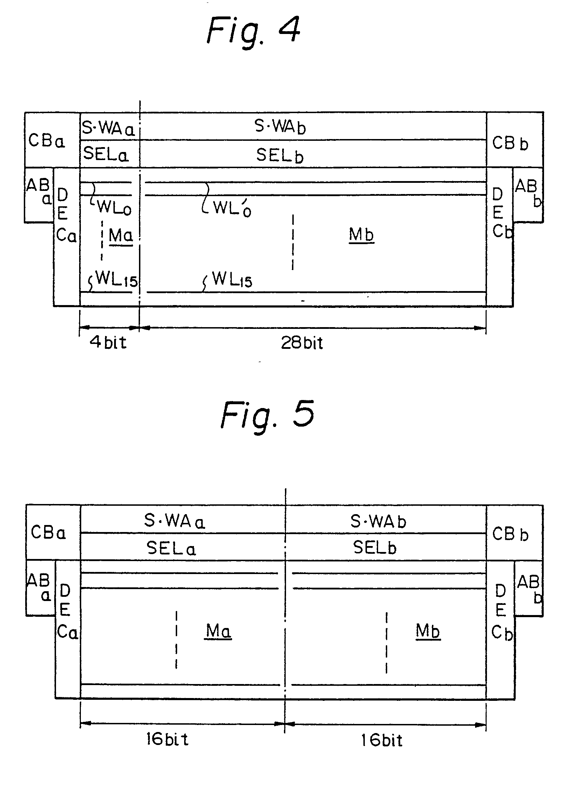

In embodiments of the present invention, not only the example mentioned above but also memories having various bit/word constitutions may be made by dividing the memory cell matrix. Such examples are shown in Figs. 4 to 8. In the Figures, reference signs also used in Fig. 2 represent like parts to those in Fig. 2.

Figure 4 is a view showing an example in which a memory of 32 words×4 bits and a memory of 32 words×28 bits are constituted.

Figure 5 is a view showing an example in which two groups of memories, each comprising 32 words×16 bits, are constituted. In this case, addresses other than the most significant bit are input in common to address registers $AB_a$ and $AB_b$, and one of the clock buffers $CB_a$ and $CB_b$ is controlled to be activated according to "1" or "0" of the most significant bit of the address, to realize a memory of 64 words×16 bits.

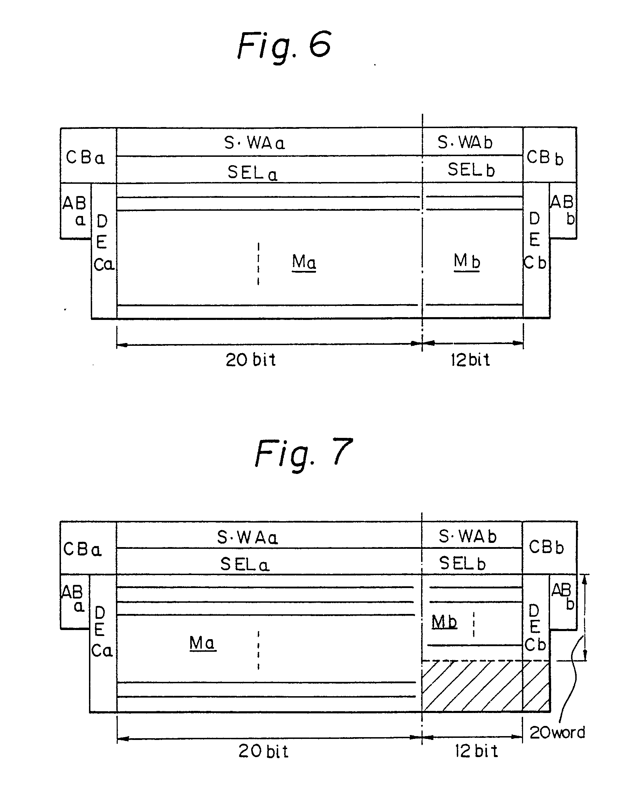

Figure 6 is a view showing an example in which a memory of 20 bit×32 words, and a memory of 32 words×12 bits are constituted.

Figure 7 is a view showing an example in which a memory of 32 words×20 bits, and a memory of 20 words×12 bits are constituted. In this case, the hatched portion of the memory cell matrix $M_b$ and the related portion of the word decoder $DEC_b$ will not be used.

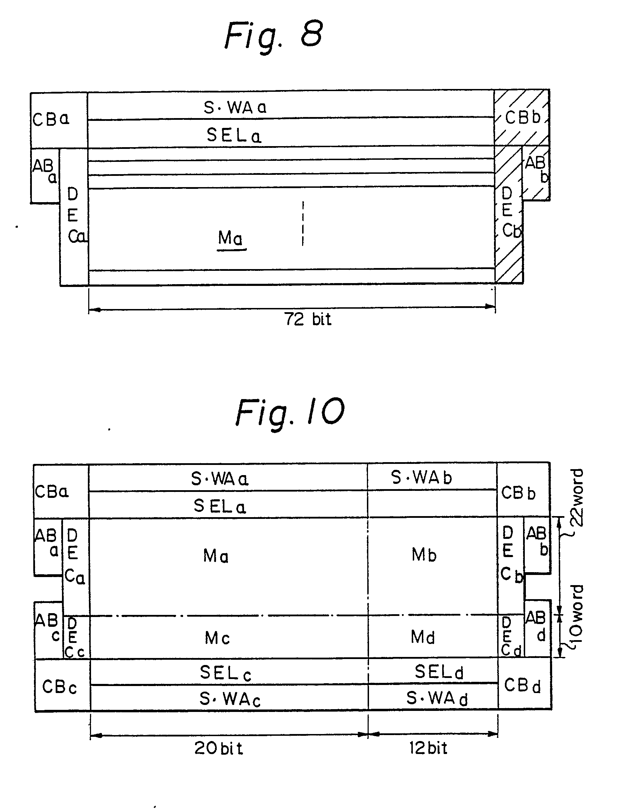

Figure 8 is a view showing an example in which a memory of 32 words×32 bits is constituted without using a hatched portion which includes the clock buffer $CB_b$, address register $AB_b$, and word decoder $DEC_b$.

As mentioned above, embodiments of the present invention provide memories having various bit/word constitutions. Since the wiring of a gate array integrated circuit device is designed automatically by means of CAD, it is preferred to register wiring patterns of typical bit/word constitutions in advance as microcells into the library of the CAD system. For instance, if a basic memory cell matrix is of a 32 words×32 bits constitution, wiring patterns for realizing the following constitutions might be registered.

|     | Memory 1         | Memory 2         |
|-----|------------------|------------------|
| (1) | 32 words× 4 bits | 32 words×28 bits |
| (2) | 32 words× 8 bits | 32 words×24 bits |
| (3) | 32 words×12 bits | 32 words×20 bits |
| (4) | 32 words×16 bits | 32 words×16 bits |
| (5) | 32 words×20 bits | 32 words×12 bits |
| (6) | 32 words×24 bits | 32 words× 8 bits |
| (7) | 32 words×23 bits | 32 words× 4 bits |

Another embodiment of the present invention in which four separate memories are constructed from a memory cell matrix will be explained.

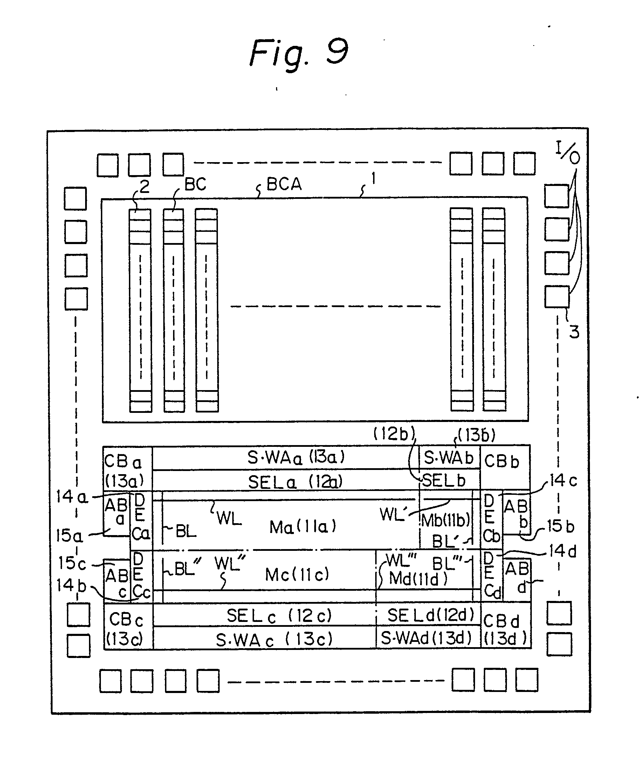

Figure 9 is a plan view showing another embodiment of the present invention. In the Figure, like numerals and marks used in Fig. 2 represent like parts. Only one word line and one bit line are shown for each memory cell matrix, other word and bit lines are omitted from the Figure. This embodiment differs from the embodiment shown in Fig. 2 in that address registers $AB_c$ and $AB_d$, clock buffers $CB_c$ and $CB_d$, column selectors $SEL_c$ and $SEL_d$, and sense and write amplifiers $S \cdot WA_c$ and $S \cdot WA_d$ are added to the constitution of Fig. 2. As a result, word lines are divided such as WL and WL', or WL'' and WL''', and bit lines also divided such as BL and BL'', or BL' and BL''' so that the mevory cell matrix may be divided into four parts to constitute four independent memories. In Fig. 9, the combination of the word decoders $DEC_a$ (14a) and $DEC_c$ (14c) corresponds to the $DEC_a$ (14a) of Fig. 2, and the combination of $DEC_b$ (14b) and $DEC_d$ (14d) to the $DEC_b$ (14b) of Fig. 2. Supposing the basic memory cell matrix of the present embodiment comprisises 32 words×32 bits, independent memories of 16 words×24 bits, 16 words×8 bits, 16 words×20 bits, and 16 words×12 bits may be formed in Fig. 9.

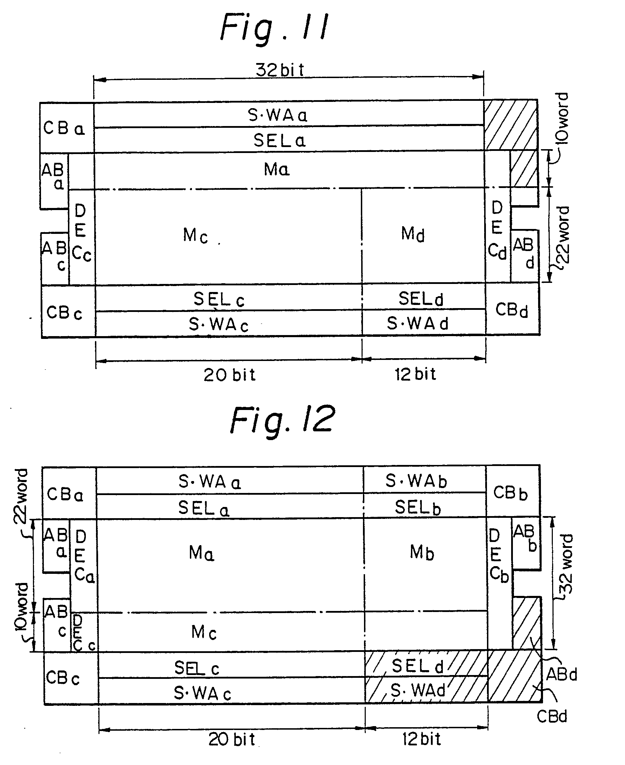

Examples of memories realized by the constitution shown in Fig. 9 will be described with reference to Figs. 10 to 14.

Figure 10 is a view showing an example in which memories of 22 words×20 bits, 22 words×12 bits, 10 words×20 bits, and 10 words×12 bits are constituted.

Fig. 11 is a view shmqing an example in which the word lines of memory cell matrix $M_a$ are not divided, and three memories of 10 words×32 bits, 22 words×20 bits, and 22 words×12 bits are constituted. In this case, the hatched clock buffer $CB_b$ and address register $AB_b$ are not used.

Figure 12 is a view showing an example in which the bit lines of the memory cell matrix $M_b$ are not divided, and memories of 22 words×20 bits, 10 words×20 bits, and 32 words×12 bits are constituted. In this case, the clock buffer $CB_d$, column selector $SEL_d$, and sense and write amplifiers $S \cdot WA_d$ are not used.

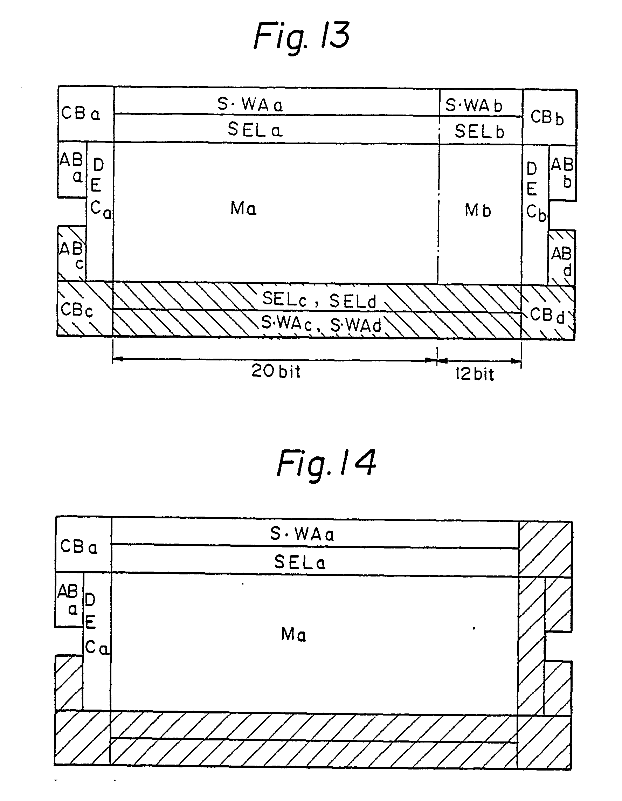

Figure 13 is a view showing an example in which the clock buffers $CB_c$ and $CB_d$, column selectors $SEL_c$ and $SEL_d$, sense and write amplifiers $S \cdot WA_c$ and $S \cdot WA_d$, and address registers $AB_c$ and $AB_d$ are not used, and the memory cell matrix is divided in the same manner as that of the embodiment shown in Fig. 2.

Fig. 14 is a view showing an example in which a single memory of 32 words×32 bits is used.

As mentioned above, four independent memories having different bit/word constitutions respectively can be constituted according to the embodiment shown in Fig. 9.

Figure 15 is a view of another embodiment of the present invention. The Figure shows only the layout of a present region portion. In this embodiment, there are provided two systems comprising address registers $AB_a$ and $AB_b$, clock buffers $CB_a$ and $CB_b$, column selectors $SEL_a$ and $SEL_b$, and sense and write amplifiers $S \cdot WA_a$ and $S \cdot WA_b$ to constitute two independent memories by dividing a bit line of the same column into BL and BL'. For instance, independent memories of 20 words×32 bits and 12 words×32 bits are realized.

Although the present invention has been explained with reference to the case in which a random access memory (RAM) is mounted on (provided in) a gate array integrated circuit device, the present invention is also applicable to a case in which a read only memory (ROM) or a programmable logic array (PLA) is mounted on (provided in) the gate array integrated circuit device.

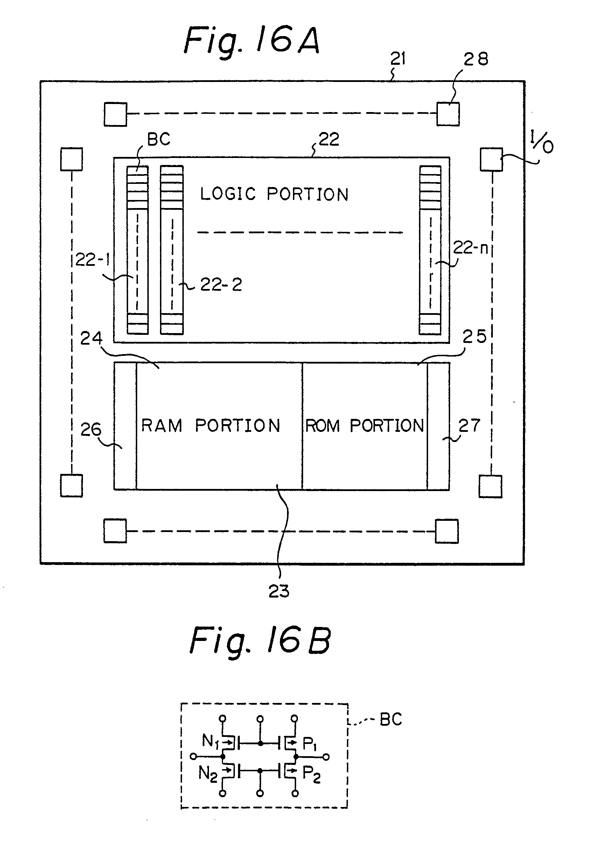

Figure 16A is further embodiment of the present invention, in which a random access memory (RAM) and a read only memory (ROM) are mounted on the device.

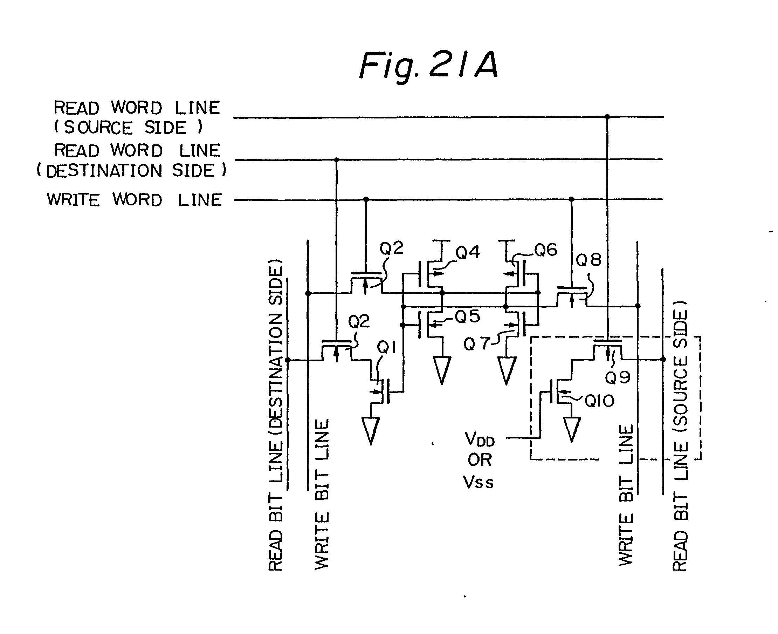

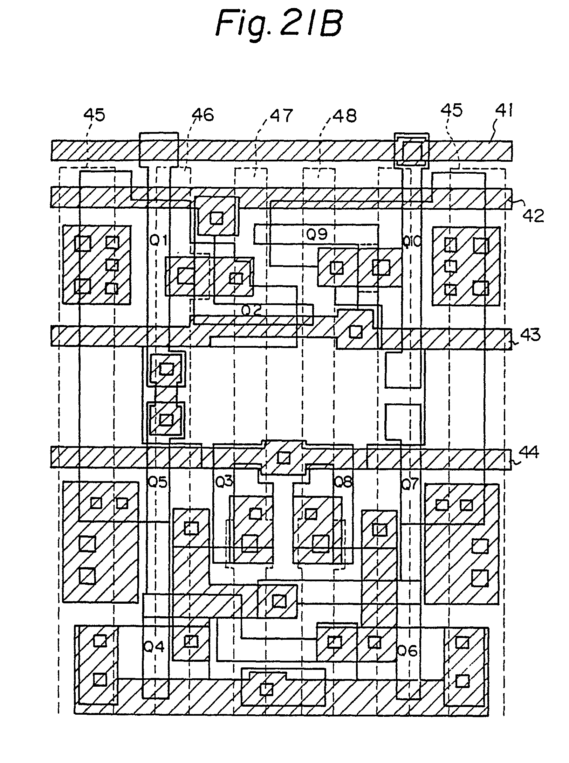

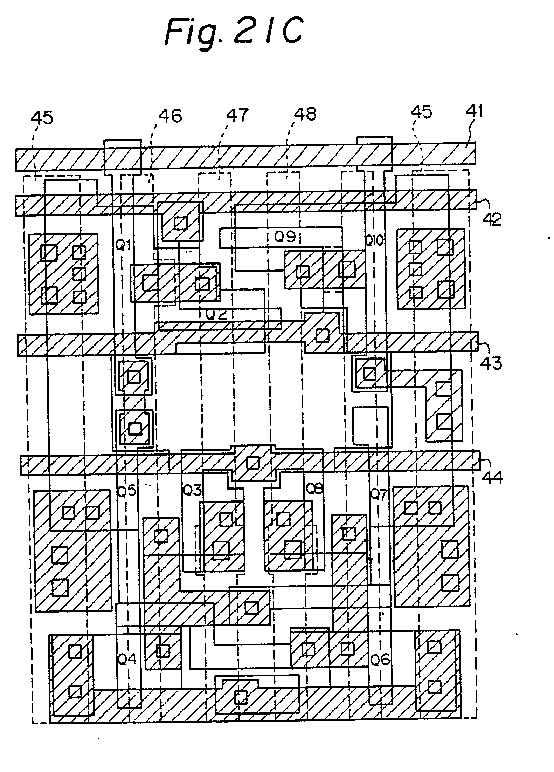

In Fig. 16A, 21 designates a chip, 22 a logic portion 22-1∾22-n basic cells arrays, 23 a memory, 24 a RAM portion, 25 a ROM portion, 26 and 27 a peripheral circuit including an address register or row decoder etc., and 28 an I/O (input/output) buffer portion. Figure 16B shows a basic cell BC. In Fig. 16B, $P_1$, $P_2$ designate P channel MIS transistors and $N_1$, $N_2$ designate N channel MIS transistors.

In Fig. 16A, the logic portion 22 includes many basic cells BC, and wiring patterns connecting between these cells can be changed so that a logic circuit satisfying the requirement of a customer can be realized. Further, many basic cells are shown in Fig. 16B are previously formed on the substrate.

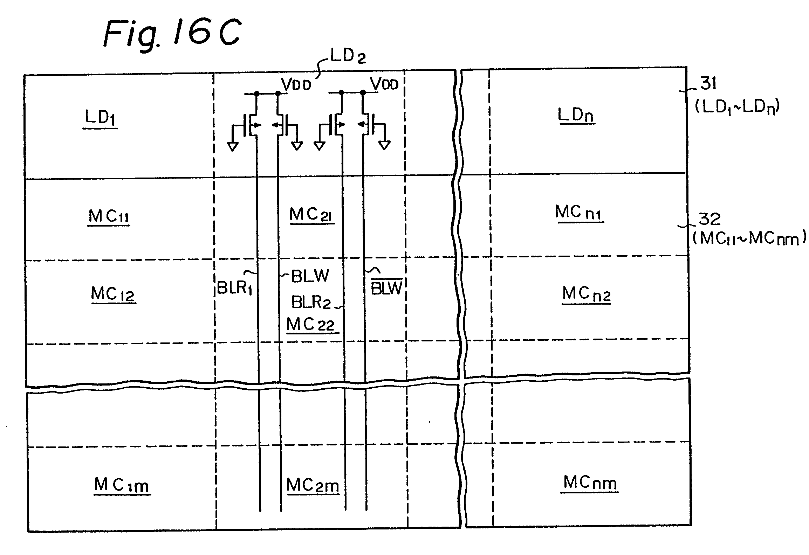

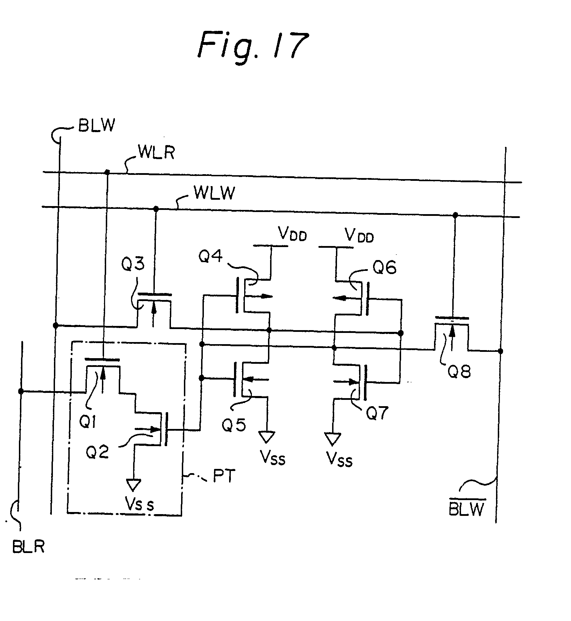

On the other hand, as the memory 23, a bulk which can be used to construct a static type RAM array having at least one output port, and the wiring thereof, is suitably selected so that the required RAM or the ROM can be constructed. Further, the output may be constructed as dual-port or 3 port. Figure 16C is a block diagram of the RAM and ROM portion of Fig. 16A. In Fig. 16A, 31 $(LD_1 ∾ LD_n)$ designates a bit line load unit and 32 $(MC_{11} ∾ MC_{nm})$ designates a memory unit. The construction of the memory cell is shown in Fig. 17. That is, Fig. 17 shows an essential portion of the circuit, indicating that it is formed by the bulk which can be used to form a static type RAM array having at least one output port.

In Fig. 17, $Q_1$ to $Q_8$ designate a transistor, (in which $Q_4$, $Q_6$ are P channel MIS type and the others are n channel MIS type), WLR a read word wire, BLR a read bit wire, WLW a writing word

wire, BLW and $\overline{BLW}$ write bit wires, and PT designates an output port respectively.

In the memory shown in Fig. 17, the output port PT is formed by the transistors $Q_1$ and $Q_2$, and a latch circuit is formed by the transistors $Q_4$, $Q_5$, $Q_6$, and $Q_7$. As is usual, the transistors $Q_3$ and $Q_8$ form a write gate.

The operation of the memory shown in Fig. 17 is well known, and therefore, only a summary of the operation will be given hereinafter.

The transistors $Q_3$ and $Q_8$ actuate for writing the data in the latch circuit. The transistor $Q_1$ is made ON or OFF in accordance with the data held in the latch circuit.

When the data is read out, the read word line WLR is placed at high (H) level, then the transistor $Q_1$ turns ON and the data held in the latch circuit is read out via the transistor $Q_2$ and output to the bit line BLR.

When such a RAM is formed, wiring is effected (connected) to all transistors.

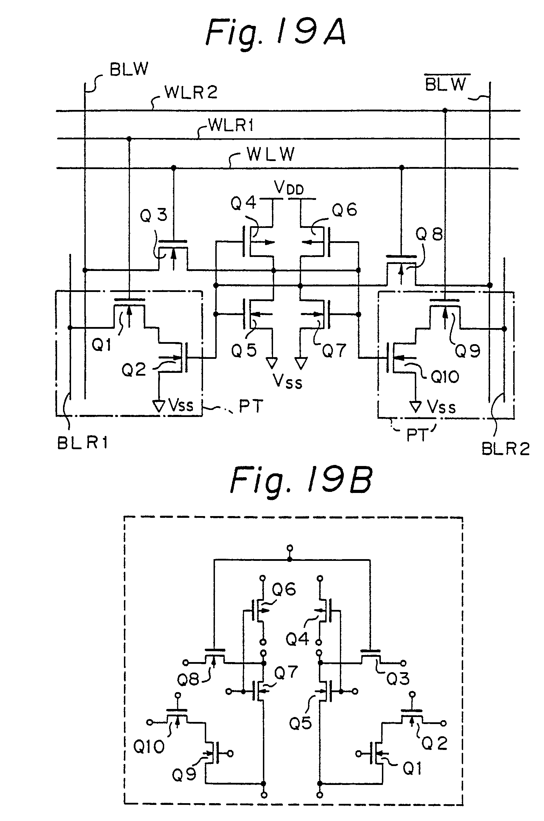

Figure 18 shows an essential portion of a concrete (completed) circuit where a ROM is formed by the bulk which can be used to form the RAM. In Fig. 18, the same symbols used in Fig. 17 designate the same portion or the same meaning as in Fig. 17. In Fig. 18, $V_{DD}$ designates a positive side source level and $V_{SS}$ designates a ground level.

When the ROM shown in Fig. 18 is formed from the bulk which can be used to form a RAM, as explained in Fig. 17, only the transistors $Q_1$ and $Q_2$ which form the port are connected as shown in Fig. 18 and the other transistors are not connected.

As shown in Fig. 18, the gate of the transistor $Q_2$ receives a positive side source voltage $V_{DD}$ or a ground side source voltage $V_{Ss}$ so as to operate as a ROM.

Figure 19A shows a concrete essential circuit showing that a bulk can be used to form a static type RAM cell array having two ports, and the same symbols as used in Figs. 17 and 18 show the same portion or have the same meaning as in Figs. 17 and 18.

In Fig. 19A, $Q_9$ and $Q_{10}$ designate a transistor, PT and PT' a port, $BLR_1$ a read out bit wire in a destination side, $BLR_2$ a read out bit wire in a source side, $WLR_1$ a read out word line in a destination side, and $WLR_2$ a read out word wire in a source side.

In the memory shown in Fig. 19A, the transistors $Q_1$ and $Q_2$ form the port PT as shown in Fig. 17, and further, the port PT' formed by the transistors $Q_9$ and $Q_{10}$ is provided so that so called dual ports are formed.

In this memory shown in Fig. 19A, the connections as for a ROM cell are made for the port PT' and the connections as for a single port RAM cell are made for the other transistors, so that this essential circuit can provide both a ROM cell and a single port RAM cell. Of course, as seen from the connection shown in Fig. 19A, the output port PT' formed by the transistors $Q_9$ and $Q_{10}$ can read at the same time the data having inverse polarity to the data which the latch circuit formed by the transistors $Q_1$, $Q_2$ reads from the latch circuit.

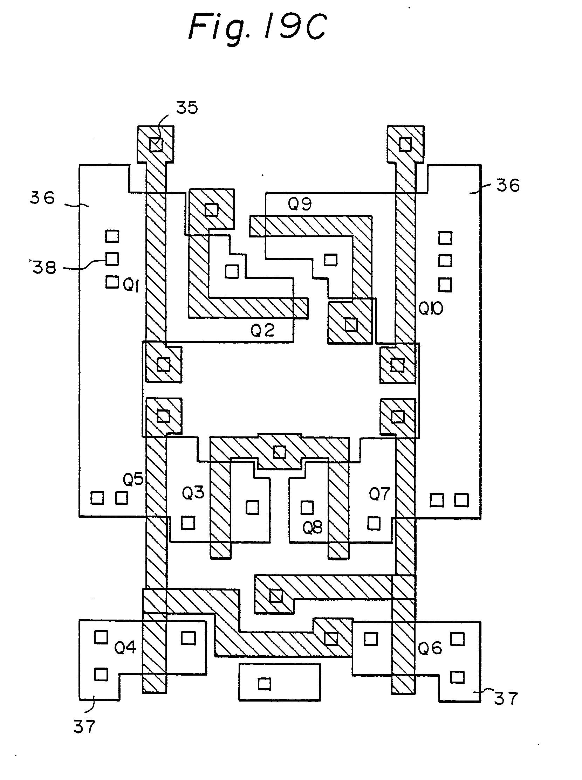

Figure 19B shows a construction of a basic cell which con form a dual port static RAM cell and Fig. 19C shows a bulk pattern for the equivalent circuit shown in Fig. 19B. The metal wire connection on the pattern shown in Fig. 19C can be changed so that a dual port RAM cell or a single port RAM cell and ROM cell or a ROM cell can be formed. In Fig. 19C, 35 designates a polysilicon gate, 36 an $N^+$ diffusion layer (source · drain), 37 an $P^+$ diffusion layer, and 38 a contact hole.

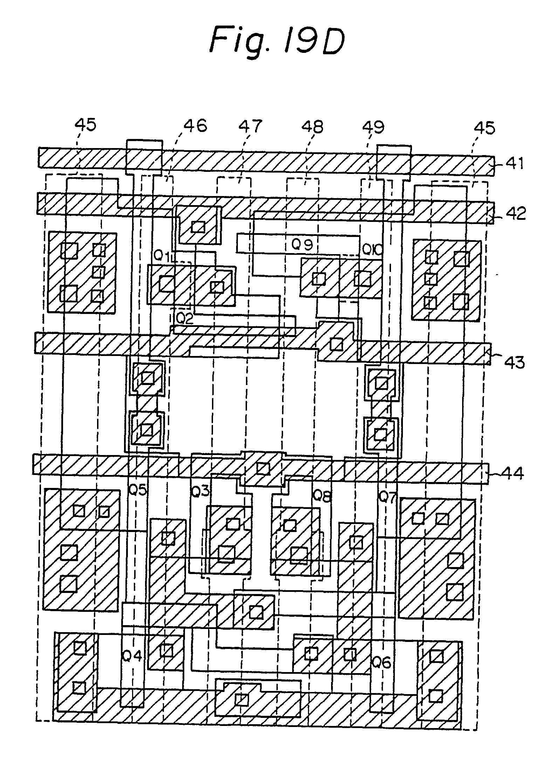

Figure 19D shows a pattern which forms a memory cell shown in Fig. 19A by providing two layers of the metal wiring to the bulk pattern shown in Fig. 19C. In Fig. 19D, 41 shows a power line, 42 a read word line (on the destination side), 43 a read word line (on the source side), 44 a write word line, 45 a ground line, 46 a read bit line (on the destination side), 47 a write bit line, 48 a write bit line, and 49 a read bit line (on the source side).

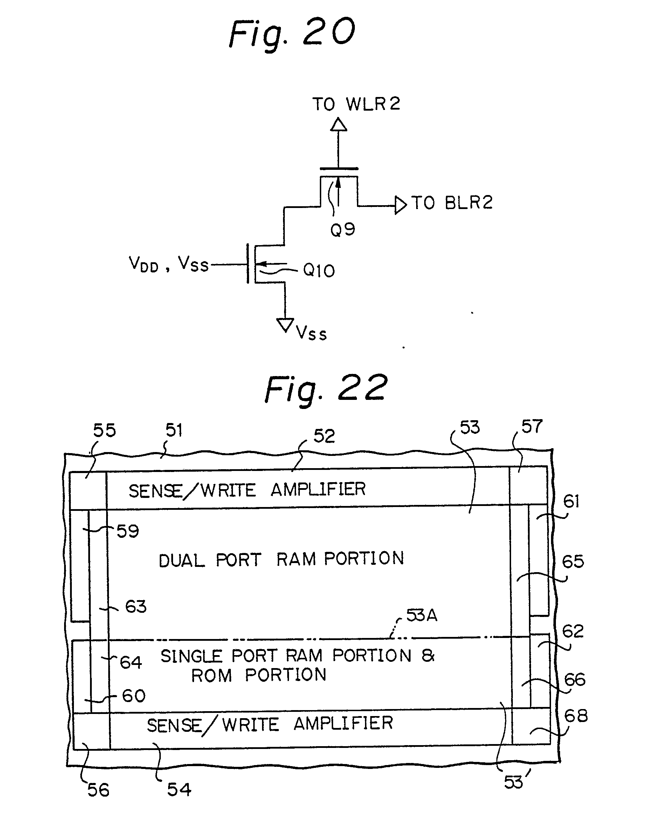

Figure 20 shows a concrete essential circuit when a ROM is formed from the bulk which can be used to form a RAM as shown in Fig. 19A, and the same symbols used in Figs. 18 and 19A show the same portions or have the same meanings as shown us in Figs. 18 and 19A.

When ROM cells as shown in Fig. 20 are formed from the bulk shown in Fig. 19A, the transistors $Q_9$ and $Q_{10}$ which form the output port PT' are connected as shown in Fig. 20 so as to form a ROM cell; and the other transistors may be connected so as to form a six-transistor single port RAM cell.

To access the single port RAM cell, the read word line $WLR_1$ on the destination side and the write word line WLW on the destination side may be used. Figure 21A shows a diagram of the circuit in which the transistors $Q_9$ and $Q_{10}$ are used as the ROM cell and the other transistors are used as the single port RAM cell. Figure 21B shows a pattern wherein single port RAM and ROM are formed by using the bulk pattern shown in Fig. 19C. Figure 21B shows a case wherein the gate of the transistor $Q_{10}$ is connected to $V_{DD}$. Figure 21C shows a pattern wherein the stored data in the ROM is the reverse of that shown in Fig. 21B. In Fig. 21B, the gate of the transistor $Q_{10}$ is connected to $V_{SS}$.

Figure 22 shows the essential portion of a further embodiment of the present invention. In Fig. 22, 51 is a chip, 52 a read and write amplifier used for a dual port RAM portion, 53 a dual port RAM portion, 53' a signal port RAM portion and ROM portion, 53A a portion where the bit lines in the main cell region are disconnected, 54 a read and write amplifier for the single port RAM portion and ROM portion, 55 a clock buffer circuit on the destination side, 56 a clock buffer circuit in the single port RAM, 57 a clock buffer circuit on the source side, 58 a clock buffer circuit in the ROM portion, 59 an address register on the destination side, 60 an address register for the RAM portion, 61 an address register for the source side, 62 an address register for the ROM portion, 63 a row decoder on the destination side, 64 a row decoder in the single port RAM, 65 a row decoder on the source side, and 66 a row decoder for the ROM portion.

As clear from Fig. 22, this embodiment corresponds to the case where the bulk which can be used to form the dual port RAM is explained with reference to Figs. 19A and 20.

Four address registers and four decoders are arranged peripherally to the memory, as shown by reference numerals 59, 60, 61, 62, and 63, 64, 65, 66. The memory is divided into the dual port RAM portion 53, the single port RAM portion and ROM portion 53', and the bit lines in the memory are divided by the two-dot line 23A. The read and write amplifier 52 is used as an input and output device for the dual port RAM portion 53 and the read and write amplifier 54 is used as an input and output device for the single port RAM portion and ROM portion 53'. Further, in the single port RAM portion and ROM portion 53', one bit (basic cell) of the dual port RAM is used as the single port RAM cell and the ROM cell.

The above-mentioned peripheral circuit, that is, the bulk of the address registers or the row decoders for the RAM portion, may be the same as that for the ROM portion. Further, it may be possible to decrease the size of region for the dual port RAM portion 53 and to increase the region for the signal port RAM portion and the ROM portion 53', or vice versa.

As described above, embodiments of the present invention enable the constitution of a plurality of independent memories having required bit/word constitutions respectively from a single memory cell array region. Accordingly, gate array integrated circuit devices having memories of different bit/word constitutions respectively may be produced according to a customer's requirement. If two (or more) independent memories are required, basic cells are not needed to constitute another memory, unlike the case of a conventional gate array integrated circuit incorporating a memory region. As a result, the integration ratio of a circuit is increased, and effectiveness in circuit designing is improved.

**Claims**

1. A gate array integrated circuit device comprising a basic cell array region in which a plurality of basic cells are arranged, a memory cell matrix region in which a plurality of memory cells are arranged, and a plurality of peripheral circuits each of which includes address input circuits and decoders for accessing said memory cells so that said memory cell matrix region may be divided to form at least two independent memories having required bit/word constitutions, each having an address input circuit and a decoder.

2. A gate array integrated circuit device according to claim 1, wherein a plurality of said memory cells are random access memory cells.

3. A gate array integrated circuit device according to claim 1, wherein said memory cell matrix region provides a bulk providing a plurality of transistors which can be form static RAM, and a ROM is formed by using at least one of said plurality of transistors.

4. A gate array integrated circuit device according to claim 1, wherein each of said memory cells comprises a plurality of transistors, wherein in each cell one or more of the transistors can be provided with wiring to form a ROM cell, and the remaining transistors can be provided with wiring to form a static RAM cell.

5. A gate array integrated circuit device according to claim 2 or 4, wherein each of said memory cells comprises a plurality of transistors which can be provided with wiring to form a dual-port static RAM cell.

6. A gate array integrated circuit device as claimed in any preceding claim, wherein a plurality of groups of wiring lines are provided for connecting respective groups of memory cells to respective peripheral circuits.

7. A gate array integrated circuit device as claimed in claim 6, wherein the wiring lines comprise word lines.

8. A gate array integrated circuit device as claimed in claim 6 or 7, wherein the wiring lines comprise bit lines.

9. A method for producing a semiconductor device comprising:

a process for forming in advance a semiconductor chip provided with a basic cell array region in which a plurality of basic cells are arranged, a memory cell matrix region in which a plurality of memory cells are arranged, and a plurality of peripheral circuits each of which includes address input circuits and decoders for accessing said memory cells;

a process for forming wiring for connecting the basic cells to each other to constitute a required logic circuit; and

a process for forming word lines separated in a word direction of said memory cell matrix or bit lines separated in a bit direction of said memory cell matrix according to a required bit/word constitution, forming at least a first and second group of word lines or bit lines and connecting each of said groups of word lines or bit lines to a respective one of said plurality of peripheral circuits to constitute at least two independent memories having said required bit/word constitutions.

**Patentansprüche**

1. Gattermatrixintegrierte Schaltungsanordnung mit einem Basiszellenmatrixbereich, in den eine Vielzahl von Basiszellen angeordnet sind, einem Speicherzellenmatrixbereich, in dem eine Vielzahl von Speicherzellenangeordnet sind, und einer Vielzahl von peripheren Schaltungen, von denen jede Adreßeingangsschaltungen und Decoder zum Zugreifen zu den Speicherzellen umfaßt, so daß der genannte Speicherzellenmatrixbereich in vier oder wenigstens zwei unabhängige Speicher unterteilt werden kann, welche die erforderliche Bit/Workkonstitution haben und jeweils eine Adreßeingangsschaltung und einen Decoder haben.

2. Gattermatrixintegrierte Schaltungsanordnung nach Anspruch 1, bei der eine Vielzahl der genannten Speicherzellen Speicherzellen mit wahlfreiem Zugriff sind.

3. Gattermatrixintegrierte Schaltungsanordnung nach Anspruch 1, bei der die genannte Speicherzellenmatrixbereich ein Grundmaterial darstellt, welches eine Vielzahl von Transistoren enthält, die ein statisches RAM bilden können, und ein ROM durch Verwendung von wenigstens einem von der genannten Vielzahl von Transistoren gebildet ist.

4. Gattermatrixintegrierte Schaltungsanordnung nach Anspruch 1, bei der jede der genannten Speicherzellen eine Vielzahl von Transistoren umfaßt, bei der in jeder Zelle einer oder mehrere Transistoren mit einer Verdrahtung zur Bildung einer ROM-Zelle versehen sein kann, und die verbleibenden Transistoren mit Verdrahtungen zur Bildung einer statischen RAM-Zelle versehen werden können.

5. Gattermatrixintegrierte Schaltungsanordnung nach Anspruch 2 oder 4, bei der jede der genannten Speicherzellen eine Vielzahl von Transistoren umfaßt, die mit einer Verdrahtung zum Bildung einer statischen Dual-Eingang-RAM-Zelle versehen werden können.

6. Gattermatrixintegrierte Schaltungsanordnung nach einem der vorhergehenden Ansprüche, bei der eine Vielzahl von Gruppen von Verdrahtungsleitungen vorgesehen sind, um jeweilige Gruppen von Speicherzellen mit entsprechenden peripheren Schaltungen zu verbinden.

7. Gattermatrixintegrierte Schaltungsanordung nach Anspruch 6, bei der die Verdrahtungsleitungen Wortleitungen umfassen.

8. Gattermatrixintegrierte Schaltungsanordnung nach Anspruch 6 oder 7, bei der die Verdrahtungsleitungen Bitleitungen umfassen.

9. Verfahren zur Herstellung einer Halbleitervorrichtung mit:

einem Verfahren, um im voraus ein Halbleiterchip zu bilden, welches einen Basiszellenanordnungsbereich aufwesit, in dem eine Vielzahl von Basiszellen angeordnet ist, einen Speicherzellenmatrixbereich, in dem eine Vielzahl von Speicherzellen angeordnet ist, und eine Vielzahl von peripheren Schaltungen, von denen jede Adreßeingangsschaltungen und Decoder zum Zugreifen zu den Speicherzellen umfaßt;

einem Verfahren zur Bildung einer Verdrahtung zur Verbindung der Basiszellen miteinander, um eine erforderliche Logikschaltung zu bilden; und

einem Verfahren zur Bildung von Wortleitungen, die in einer Wortrichtung der genannten Speicherzellenmatrix getrennt sind, oder von Bitleitungen, die in einer Bitrichtung der genannten Speicherzellenmatrix getrennt sind, entsprechend einer erforderlichen Bit/Wortkonstitution, welche wenigstens erste und zweite Gruppen von Wortleitungen oder Bitleitungen bilden, und Verbinden jeder der genannten Gruppen von Wortleitungen oder Bitleitungen einer entsprechenden der genannten Vielzahl von peripheren Schaltungen, um wenigstens zwei unabhängige Speicher zu bilden, welche die erforderliche Bit/Wortkonstitutionen aufweisen.

## Revendications

1. Dispositif en circuit intégré à circuits prédiffusés comprenant une région de matrice de cellules de base dans laquelle sont disposées un ensemble de cellules de base, une région de matrice de cellules de mémoire dans laquelle sont disposées un ensemble de cellules de mémoire, et un ensemble de circuits périphériques dont chacun comprend des circuits d'entrée d'adresse et des décodeurs pour avoir accès aux cellules de mémoire, de sorte que la région de matrice de cellules de mémoire peut être divisée pour former au moins deux mémoires indépendantes ayant une constitution en bits/mots voulue comportant chacune un circuit d'entrée d'adresse et un décodeur.

2. Dispositif en circuit intégré à circuits prédiffusés selon la revendication 1, dans lequel un ensemble des cellules de mémoir sont des cellulse de mémoire à accès sélectif (RAM).

3. Dispositif en circuit intégré à circuits prédiffusés selon la revendication 1, dans lequel la région de matrice de cellules de mémoire fournit un corps fournissant un ensemble de transistors qui peuvent constituer une mémoire RAM statique, et une mémoire morte (ROM) est formée en utilisant au moins un de l'ensemble de transistors.

4. Dispositif en circuit intégré à circuits prédiffusés selon la revendication 1, dans lequel chacune des cellules de mémoire comprend un ensemble de transistors, dans lequel on peut prévoir dans chaque cellule un ou plusieurs des transistors avec un câblage pour former une cellule de mémoire ROM, et on peut prévoir les autres transistors avec un câblage pour former une cellule de mémoire RAM statique.

5. Dispositif en circuit intégré à circuits prédiffusés selon l'une quelconque des revendications 2 et 4, dans lequel chacune des cellules de mémoire comprend un ensemble de transistors qui peuvent être prévus avec un câblage pour former une cellule de mémoire RAM statique à porte d'accès double.

6. Dispositif en circuit intégré à circuits prédiffusés selon l'une quelconque des revendications 1 à 5, dans lequel un ensemble de groupes de fils de câblage sont prévus pour connecter des groupes respectifs de cellules de mémoire aux circuits périphériques respectifs.

7. Dispositif en circuit intégré à circuits prédiffusés selon la revendication 6, dans lequel les fils de câblage comprennent des fils de mot.

8. Dispositif en circuit intégré à circuits prédiffusés selon l'une quelconque des revendications 6 et 7, dans lequel les fils de câblage comprennent des fils de bit.

9. Procédé pour fabriquer un dispositif à semiconducteur consistant en:
une opération pour former d'avance une puce à semiconducteur pourvue d'une région de matrice de cellules de base dans laquelle sont disposées un ensemble de cellules de base, une région de matrice de cellules de mémoire dans laquelle sont disposées un ensemble de cellule de mémoire, et un ensemble de circuits périphériques dont chacun comprend des circuits d'entrée d'adresse et des décodeurs pour avoir accès aux cellules de mémoire;
une opération pour former un câblage destiné à connecter les cellules de base entre elles pour constituer un circuit logique voulu; et
une opération pour former des fils de mot séparés dans une direction de mots de la matrice de cellules de mémoire ou des fils de bit séparés dans une direction de bits de la matrice de cellules de mémoire selon une constution en bits/mots voulue, pour former au moins un premier et un deuxième groupe de fils de mot ou de fils de bit, et pour connecter chacun des groupes de fils de mot ou de fils de bit à un circuit respectif de l'ensemble de circuits périphériques afin de constituer au moins deux mémoires indépendantes ayant les constitutions en bits/molts voulues.

# Fig. I

# Fig. 2

Fig. 3A

Fig. 3

| Fig. 3A | Fig. 3B |
|---------|---------|

# Fig. 3B

## Fig. 4

## Fig. 5

5

## *Fig. 6*

| CBa | S·WAa | | S·WAb | CBb |
| --- | SELa | | SELb | --- |
| ABa / DECa | | Ma | Mb | DECb / ABb |

20 bit          12 bit

## *Fig. 7*

| CBa | S·WAa | | S·WAb | CBb |
| --- | SELa | | SELb | --- |
| ABa / DECa | Ma | | Mb | DECb / ABb |

20 bit          12 bit          20 word

## Fig. 8

## Fig. 10

# Fig. 9

# Fig. 11

32 bit

10 word

22 word

| CB a | S·WA a |
| | SEL a |

AB a

Ma

| AB c | D E C c | Mc . | Md | D E C d | AB d |

| CB c | SEL c | SEL d | CB d |
| | S·WA c | S·WA d | |

20 bit

12 bit

# Fig. 12

22 word

10 word

| CB a | S·WA a | S·WA b | CB b |
| | SEL a | SEL b | |

32 word

| AB a | D E C a | Ma | Mb | D E C b | AB b |

| AB c | D E C c | Mc | | | |

| CB c | SEL c | SEL d | |
| | S·WA c | S·WA d | |

ABd

CBd

20 bit

12 bit

## Fig. 13

## Fig. 14

## Fig. 15

| CBa | | | S·WAa | |
|---|---|---|---|---|
| | | | SELa | |
| ABa | D E Ca | | WL$_0$ BL | Ma |
| ABb | D E Cb | | BL' WL$_{15}$ | Mb |
| CBb | | | SELb | |
| | | | S·WAb | |

## Fig. 18

TO WLR

TO BLR ◁

Q1

V$_{DD}$ , V$_{SS}$

Q2

V$_{SS}$

## Fig. 16A

BC

LOGIC PORTION

21 28

22

I/O

22-1 22-n

22-2

24 25

RAM PORTION ROM PORTION

26 27

23

## Fig. 16B

BC

$N_1$ $P_1$

$N_2$ $P_2$

EP 0 184 464 B1

## Fig. 16C

LD₂

LD₁

VDD   VDD

LDₙ

31 (LD₁~LDₙ)

MC₁₁   MC₂₁   MCₙ₁

32 (MC₁₁~MCₙₘ)

MC₁₂   BLR₁   BLW   BLW̄   MCₙ₂

BLR₂
MC₂₂

MC₁ₘ   MC₂ₘ   MCₙₘ

# Fig. 17

# Fig. 19A

# Fig. 19B

15

## Fig. 19C

## Fig. 19D

## Fig. 20

TO WLR2

TO BLR2

Q9

$V_{DD}$ , $V_{SS}$ — Q10

$V_{SS}$

## Fig. 22

| 55 | 51 | 52 | 53 | 57 |
|---|---|---|---|---|

SENSE/WRITE AMPLIFIER

61

59

DUAL PORT RAM PORTION

65

63

53A

62

64 SINGLE PORT RAM PORTION & ROM PORTION

60

66

SENSE/WRITE AMPLIFIER

68

56 54 53'

Fig. 21A

# Fig. 21B

# Fig. 21C